Europäisches Patentamt

(19) European Patent Office

Office européen des brevets

(11) Numéro de publication: **0 296 930**
**B1**

(12) # FASCICULE DE BREVET EUROPEEN

(45) Date de publication du fascicule du brevet:
16.08.90

(51) Int. Cl.⁵: **H03K 17/22**

(21) Numéro de dépôt: 88401432.5

(22) Date de dépôt: **10.06.88**

(54) Circuit de remise sous tension pour circuit intégré en technologie MOS.

(30) Priorité: **12.06.87 FR 8708190**

(43) Date de publication de la demande:
**28.12.88 Bulletin 88/52**

(45) Mention de la délivrance du brevet:
**16.08.90 Bulletin 90/33**

(84) Etats contractants désignés:
**DE ES GB IT NL**

(56) Documents cités:
**US-A- 4 365 174**
**US-A- 4 419 596**

**PATENT ABSTRACTS OF JAPAN,
vol. 5, no. 192 (E-85)[864], 8 décembre 1981; &
JP-A-56 116 323 (SHARP K.K.) 12-09-1981
PATENT ABSTRACTS OF JAPAN,
vol. 8, no. 159 (P-289)[1596], 24 juillet 1984; &
JP-A-59 57 316 (TOKYO DENKI K.K.) 02-04-1984**

(73) Titulaire: **SGS-THOMSON MICROELECTRONICS S.A., 7,
Avenue Galliéni, F-94250 Gentilly(FR)**

(72) Inventeur: **Dubujet, Bruno, 91 Clos de la Cause Palette,
F-13100 le Tholonet(FR)**

(74) Mandataire: **Ballot, Paul Denis Jacques et al, Cabinet
Ballot-Schmit 7, rue le Sueur, F-75116 Paris(FR)**

ACTORUM AG

# Description

La présente invention concerne un circuit de remise sous tension d'un circuit intégré en technologie MOS (Métal, Oxyde, Semiconducteur) plus particulièrement d'un circuit intégré en technologie C-MOS (MOS complémentaire).

Dans certains types de circuits intégrés, tout particulièrement ceux qui contiennent des bascules, il est important que certains points du circuit prennent un état logique bien défini lorsqu'on met le circuit sous tension après une interruption de l'alimentation. En effet, il faut éviter que des états logiques incertains ou erronés n'apparaissent durant la montée de la tension d'alimentation et ne se répercutent ensuite durant le fonctionnement du circuit.

Or, l'état des noeuds d'un circuit logique ne peut véritablement prendre une valeur certaine que si la tension d'alimentation du circuit dépasse une valeur minimale. A titre d'exemple, pour un circuit logique réalisé en technologie C-MOS, cette valeur minimale est de 3 volts. Pour une tension inférieure, les noeuds ont des potentiels variables qui dépendent plus des couplages capacitifs du circuit que de données purement logiques. D'autre part, ces potentiels peuvent différer d'un circuit à l'autre dans une fabrication en série.

Pour remédier à cet inconvénient, on utilise donc un circuit de remise sous tension qui délivre une impulsion de positionnement lorsque la tension d'alimentation a atteint une valeur suffisante pour permettre de positionner le circuit logique grâce à un cycle de fonctionnement à vide. Les circuits de remise sous tension actuellement disponibles sur le marché sont en général complexes du fait de l'absence d'une tension d'alimentation stabilisée. Ils sont le plus souvent réalisés en utilisant les tensions de seuil de transistors MOS, la charge de capacités et des rebouclages multiples avec réactions positives et négatives.

A titre d'exemple de circuits de remise sous tension de l'art antérieur, on peut citer le brevet US– A 4 365 174 qui décrit un système avec une temporisation par un compteur, le brevet US–A 4 419 596 qui comporte des bascules dont on vérifie l'état, et l'abrégé du recueil "Patent Abstracts of Japan", vol 5 N°192 (JP–A 56 116 323) qui comporte une temporisation suivie du démarrage d'un oscillateur.

La présente invention a pour but de proposer un nouveau circuit de remise sous tension particulièrement simple et efficace par rapport aux circuits de remise sous tension de l'art antérieur.

Ainsi, la présente invention a pour objet un circuit de remise à zéro à la mise sous tension pour assurer le démarrage d'un circuit intégré en technologie MOS, caractérisé en ce qu'il comprend des premiers moyens pour générer à partir d'une tension d'alimentation, une tension supérieure à ladite tension d'alimentation et un deuxième moyen pour mesurer l'écart entre la tension d'alimentation et la tension générée et pour générer un signal de remise à zéro lorsque l'écart atteint un seuil donné après l'application de la tension d'alimentation.

La présente invention part de la constatation que la complexité des circuits de remise sous tension de l'art antérieur est due à l'absence d'alimentation. En conséquence, elle résoud ce problème en créant une alimentation spécifique grâce à des moyens générant une tension supérieure à la tension d'alimentation non stabilisée.

Selon un mode de réalisation préférentiel, les premiers moyens sont constitués par un oscillateur connecté à un élévateur de tension délivrant en sortie une tension supérieure à la tension d'alimentation. De préférence, l'oscillateur est constitué par un nombre impair d'inverseurs montés en série, la sortie du dernier inverseur étant rebouclée sur l'entrée du premier inverseur et l'élévateur de tension comprend une première diode montée en direct entre la borne d'alimentation et un premier noeud de circuit, une première capacité montée entre le premier noeud et la première sortie d'un inverseur, une deuxième diode montée en direct entre le premier noeud et un deuxième noeud de circuit et une deuxième capacité montée entre le deuxième noeud et la sortie d'un deuxième inverseur monté en série avec le premier inverseur, la sortie de l'élévateur étant prise sur le deuxième noeud.

Pour régler le seuil de la tension de sortie, l'élévateur de tension peut comporter un ou plusieurs étages supplémentaires. Chaque étage supplémentaire est constitué par exemple par une diode montée en direct entre un avant dernier noeud de circuit et un dernier noeud de circuit formant la sortie de l'élévateur de tension et une capacité montée entre le dernier noeud et la sortie d'un inverseur supplémentaire monté en série avec les autres inverseurs. Le dernier étage est constitué par une diode montée en direct entre le dernier noeud du circuit et un noeud suivant formant la sortie de l'élévateur de tension et une capacité montée entre le noeud suivant et une tension basse ou masse. Ceci permet de réaliser le filtrage final de la tension générée.

D'autre part, le deuxième moyen est constitué par un circuit de comparaison recevant respectivement sur chaque entrée la tension générée et la tension d'alimentation et délivrant en sortie un signal fonction de l'écart entre les deux tensions et par un circuit de détection et de mise en forme connecté en sortie du circuit de comparaison et générant le signal de mise sous tension. Ce circuit de comparaison est constitué par deux transistors MOS de type N connectés en série entre un générateur de courant et la tension basse ou masse. De même, le circuit de détection et mise en forme est constitué par deux portes inverseuses.

Selon une autre caractéristique de la présente invention, pour éviter que le circuit de mise sous tension continue à consommer du courant alors que la mise sous tension est réalisée, il comporte de plus des moyens pour arrêter le fonctionnement du circuit une fois généré le signal de mise sous tension.

Selon un mode de réalisation préférentiel, ces moyens pour arrêter le fonctionnement du circuit une fois généré le signal de mise sous tension sont constitués par des portes NON-OU prévues respectivement dans la boucle de l'oscillateur et dans le circuit de détection et mise en forme, ces portes NON-OU recevant sur une de leurs entrées le signal de mise sous tension. Les moyens pour arrêter le fonctionnement du circuit réalise aussi le blocage du générateur de courant.

Selon encore une autre caractéristique de la présente invention, lorsque le circuit de mise sous tension est réalisé en technologie C-MOS, les diodes utilisées dans l'élévateur de tension sont constituées par un transistor MOS de type P dont les trois électrodes sont connectées ensemble et forment la cathode et dont le caisson N forme l'anode.

D'autres caractéristiques et avantages de la présente invention apparaîtront à la lecture de la description d'un mode de réalisation préférentiel faite avec référence aux dessins ci-annexés, dans lesquels:

- la figure 1 est un schéma de principe d'un circuit de remise sous tension conforme à la présente invention,
- la figure 2 est un schéma d'un mode de réalisation du circuit de la figure 1,
- la figure 3 est un schéma d'une diode utilisée dans le circuit de la figure 2, et
- la figure 4 représente des courbes V(t) en différents points du circuit.

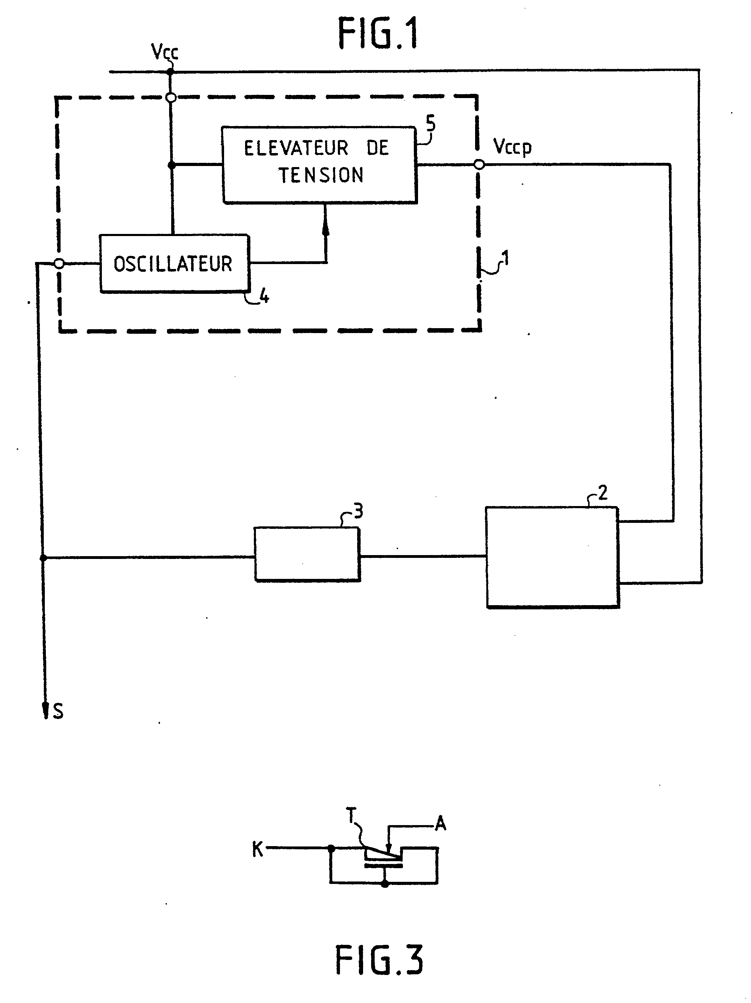

Comme représenté sur la figure 1, le circuit de remise sous tension conforme à la présente invention comporte essentiellement un premier moyen 1 pour générer à partir de la tension d'alimentation $V_{cc}$ extérieure au circuit intégré une tension $V_{ccp}$ supérieure à ladite tension d'alimentation, un deuxième moyen 2 pour mesurer l'écart entre la tension extérieure $V_{cc}$ et la tension générée $V_{ccp}$ et générer un signal de mise sous tension et des moyens 3 pour arrêter le fonctionnement du circuit une fois généré le signal S de mise sous tension.

Le premier moyen 1 est constitué essentiellement d'un oscillateur 4. Dans le mode de réalisation représenté, la fréquence de cet oscillateur dépend de la tension d'alimentation $V_{cc}$. Cet oscillateur est connecté à un élévateur de tension 5 recevant aussi la tension d'alimentation $V_{cc}$ et délivrant en sortie ladite tension $V_{ccp}$. D'autre part, l'oscillateur reçoit le signal de sortie des moyens 3 de manière à bloquer son fonctionnement lorsque le signal S de mise sous tension vient d'être généré.

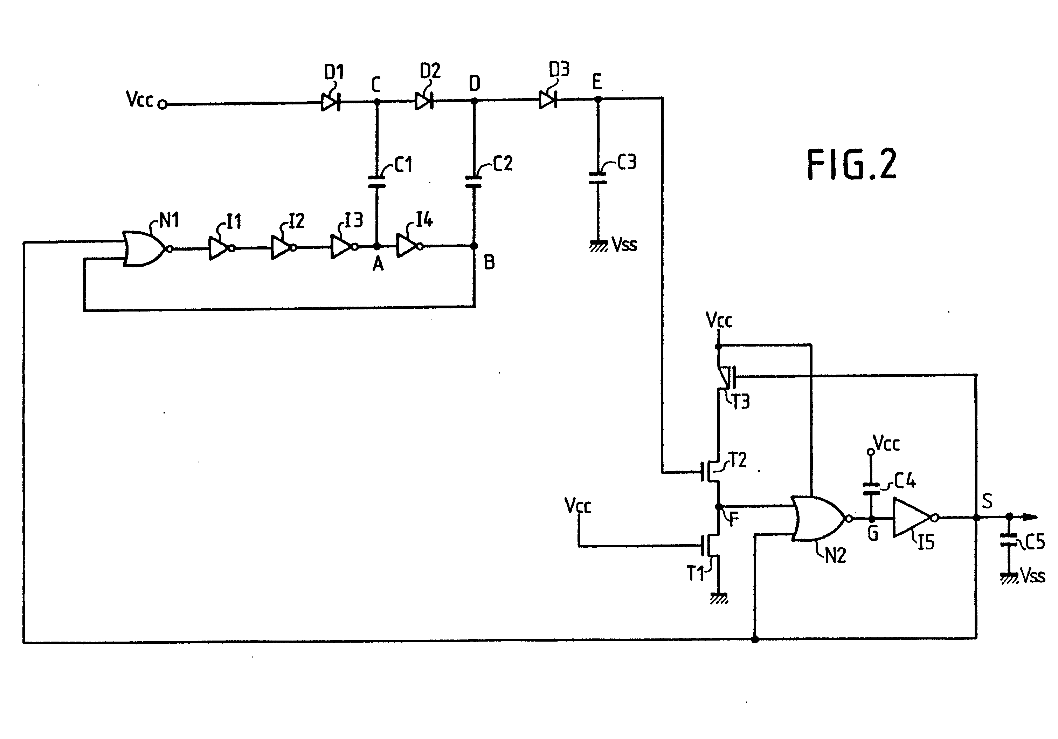

Le circuit de la figure 1 peut être réalisé de la manière représentée sur la figure 2. Ainsi, l'oscillateur 4 est constitué par un nombre impair d'inverseurs, à savoir les quatre inverseurs $I_1$, $I_2$, $I_3$, $I_4$ et la porte NON-OU $N_1$ dans le mode de réalisation représenté, la sortie de l'inverseur $I_4$ étant rebouclée sur une des entrées de la porte NON-OU $N_1$. La fréquence d'oscillation de l'oscillateur est donc fonction du nombre et du temps de propagation des inverseurs. Elle dépendra aussi de la tension d'alimentation $V_{cc}$.

D'autre part, l'élévateur de tension 5 est constitué essentiellement par une première diode $D_1$ montée en directe entre la tension d'alimentation extérieure $V_{cc}$ et un premier noeud C de circuit, une première capacité $C_1$ montée entre le premier noeud C de circuit et le noeud A en sortie de l'inverseur $I_3$, une deuxième diode $D_2$ montée en direct entre le premier noeud C et un deuxième noeud D de circuit et une deuxième capacité $C_2$ montée entre le deuxième noeud D et le noeud B en sortie d'un deuxième inverseur $I_4$ monté en série avec le premier inverseur $I_3$.

D'autre part, l'élévateur de tension comporte, dans le mode de réalisation représenté, un étage de filtrage constitué par une troisième diode $D_3$ montée en direct entre le deuxième noeud D de circuit et un troisième noeud E de circuit formant la sortie de l'élévateur de tension et une capacité $C_3$ montée entre le troisième noeud et une tension basse ou masse $V_{ss}$. Ce circuit permet d'obtenir sur le noeud E une tension générée $V_{ccp}$ supérieure à la tension d'alimentation $V_{cc}$ comme cela sera expliqué de manière plus détaillée ci-après.

Suivant la tension de sortie souhaitée, l'élévateur de tension peut contenir des étages supplémentaires. Chaque étage supplémentaire est alors constitué par une diode montée en direct entre le deuxième noeud de circuit et un troisième noeud de circuit et une capacité montée entre le troisième noeud et la sortie d'un inverseur. L'étage de filtrage est alors connecté au troisième noeud.

Conformément à la présente invention, le noeud E est relié sur une des entrées d'un circuit de comparaison qui reçoit sur son autre entrée la tension d'alimentation extérieure $V_{cc}$.

Comme représenté sur la figure 2, ce circuit de comparaison est constitué par deux transistors MOS de type N $T_1$, $T_2$ montés en série entre la tension basse ou masse $V_{ss}$ et un générateur de courant. Le générateur de courant est constitué, dans le mode de réalisation représenté, par un transistor MOS de type P $T_3$ dont une des électrodes est connectée au diviseur résistif formé par les deux transistors $T_1$, $T_2$, dont l'autre électrode est connectée à la tension d'alimentation extérieure $V_{cc}$ et dont la grille est connectée, dans le mode de réalisation représenté, à la sortie S. Le noeud commun F entre les deux transistors $T_1$ et $T_2$ est connecté sur une des entrées d'une porte NON-OU $N_2$ qui reçoit sur son autre entrée le signal de sortie S du circuit. La sortie de la porte NON-OU $N_2$ est envoyée sur un inverseur $I_5$ qui délivre en sortie le signal S de mise sous tension. En fait, la porte NON-OU $N_2$ et l'inverseur $I_5$ constituent un circuit de détection et mise en forme qui délivre le signal S de mise sous tension lorsque le signal au niveau du noeud F atteint un seuil donné.

Dautre part, dans le mode de réalisation représenté, le signal de mise sous tension ou signal de sortie S est aussi connecté en entrée de la porte NON-OU $N_1$. Le fait de connecter le signal S de mise sous tension avec l'oscillateur 4, le circuit de détection et mise en forme constitué des portes $N_2$ et $I_5$ et le générateur de courant $T_3$ permet d'arrêter le fonctionnement du circuit de remise sous tension une fois le signal de mise sous tension généré. Cet arrêt est important car il permet d'éviter que le circuit de remise sous tension ne consomme du courant alors qu'il n'est plus utile puisque la tension d'alimentation externe a atteint son seuil de fonctionnement. Dans un circuit de remise sous tension ne comportant pas de moyens pour arrêter le fonctionnement du circuit, les portes NON-OU $N_1$ et $N_2$ peuvent être remplacées par des inverseurs et la grille du transistor $T_3$ être connectée à la tension basse ou masse.

D'autre part, pour obtenir un postionnement correct de certains noeuds du circuit à la mise sous tension, on prévoit des capacités de stabilisation. Ainsi une capacité $C_4$ est connectée entre la tension d'alimentation extérieure $V_{cc}$ et le point commun prévue entre la porte $N_2$ et l'inverseur $I_5$ et une capacité $C_5$ est connectée entre le noeud S et la tension basse ou masse $V_{ss}$.

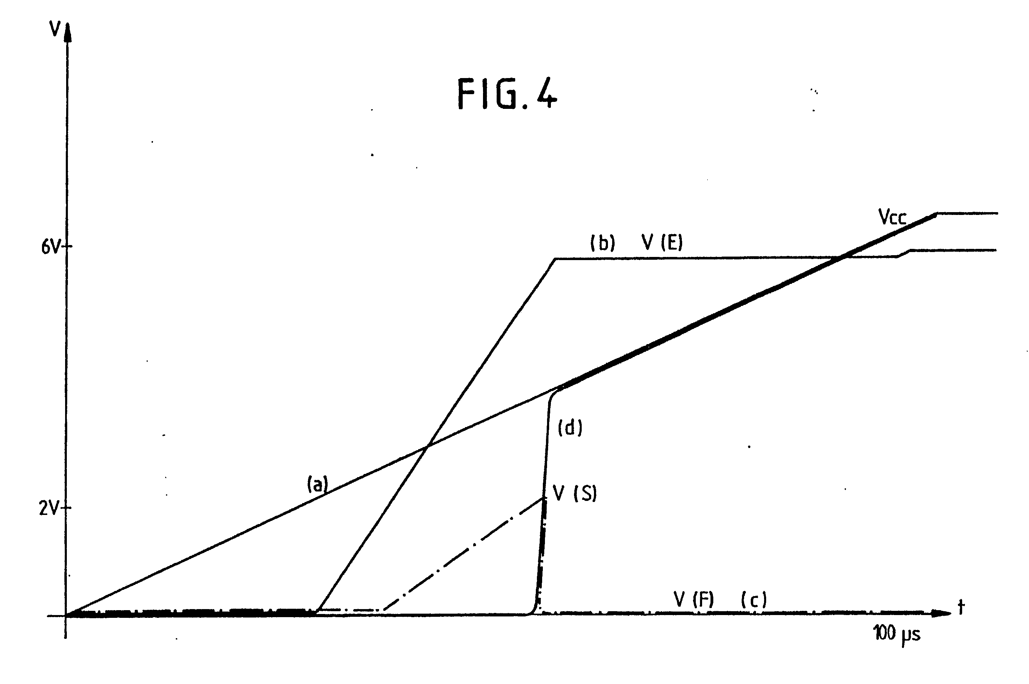

On expliquera, ci-après, le fonctionnement du circuit représenté à la figure 2 avec l'aide des courbes de la figure 4.

On expliquera, tout d'abord, le fonctionnement de l'ensemble oscillateur-élévateur de tension. Pour que l'oscillateur puisse fonctionner, il est nécessaire que la tension d'alimentation extérieure $V_{cc}$ atteigne au moins la tension de seuil des inverseurs constituant l'oscillateur. A partir de ce moment, lorsque le noeud A se trouve au niveau logique "0", la capacité $C_1$ se charge à une tension correspondant à $V_{cc}-V_{td}$, $V_{td}$ étant la tension de seuil des diodes. Dans ce cas, le point B est positionné à un niveau haut égal à $V_{cc}$ et le point D se trouve être à une tension sensiblement égale à $V_{cc} - 2\,V_{td}$. Lorsque le noeud A passe au niveau logique "1", c'est-à-dire à la tension $V_{cc}$, le noeud C passe à une tension égale à $2\,V_{cc} - V_{td}$, car la capacité $C_1$ n'a pas eu le temps de se décharger. La diode $D_1$ est alors bloquée. Le noeud B se retrouve au niveau logique "0" et le noeud D est aussi au niveau logique "0" car $C_2$ n'est pas chargé. Il passe alors à la tension $2\,V_{cc} - 2\,V_{td}$ et le noeud E qui était sensiblement à 0 volt passe à la tension $2\,V_{cc} - 3\,V_{td}$. En même temps, les deux capacités $C_2$ et $C_3$ se sont chargées, ce qui permet de maintenir la tension au point E sensiblement à $2\,V_{cc} - 3\,V_{td}$. Toutefois, le circuit décrit ci-dessus peut fonctionner lorsque $V_{cc}$ est supérieur à $3\,V_{td}$, c'est-à-dire, avec une tension de seuil pour les diodes de 0,5 volt, à partir de 1,5 volt. Toutefois, le circuit fonctionne correctement à partir d'une tension $V_{cc}$ sensiblement égale à 2,5 volts à cause des effets substrat. D'autre part, la fréquence d'oscillation de l'oscillateur est telle qu'une fois chargées les différentes capacités $C_1$, $C_2$, $C_3$ ne se déchargent presque pas lors des commutations des points A et B entre les niveaux hauts et bas et l'on obtient donc sur le noeud E une tension générée $V_{ccp}$ supérieure à $V_{cc}$ sensiblement indépendante de la fréquence d'oscillation. Ainsi, avec le circuit décrit ci-dessus pour une tension $V_{cc}$ croissant linéairement jusqu'à ≃ 7 V comme représenté par la courbe (a), on obtient au point E la tension représentée par la courbe b, le circuit commençant à fonctionner pour une tension $V_{cc} \simeq 2,5$ volts.

La tension $V_{ccp}$ est envoyée sur la grille du transistor $T_2$ tandis que la grille du transistor $T_1$ reçoit la tension d'alimentation extérieure $V_{cc}$. Avec le diviseur résistif formé des transistors $T_1$, $T_2$ et le générateur de courant $T_3$ générant un courant en fonction de l'alimentation $V_{cc}$, tant que la tension $V_{ccp}$ est inférieure à la tension de seuil du transistor $T_2$, la tension au noeud F reste à 0 comme représenté par la courbe c sur la figure 4. Ensuite, avec
$V_{T2} < V_{ccp} < V_{cc}$,
la tension au point F reste faible car le transistor $T_2$ est plus résistif que le transistor $T_1$, puis lorsque la tension $V_{ccp}$ devient supérieure à $V_{cc}$, la tension au noeud F augmente, le transistor $T_2$ devenant de moins en moins résistif. Lorsque la tension au noeud F arrive à la tension de seuil de la porte NON-OU $N_2$ celle-ci bascule. Dans le mode de réalisation de la présente invention, la tension de seuil de la porte NON-OU est positionnée à l'aide des transistors la constituant. Le basculement de la porte NON-OU $N_2$ à un niveau logique "0" fait basculer l'inverseur $I_5$ au niveau logique "1" envoyant un signal S de mise sous tension vers le circuit intégré. Ce signal de mise sous tension est aussi envoyé vers la porte NON-OU $N_2$ la faisant aussitôt rebasculer au niveau logique "1", vers la porte NON-OU $N_1$ de manière à bloquer l'oscillateur et vers le générateur de courant $T_3$ de manière à l'arrêter. Pour obtenir un positionnement correct à la mise sous tension, le noeud G est initialement positionné à un niveau logique "1" par l'intermédiaire de la capacité $C_4$ reliée à la tension d'alimentation $V_{cc}$, tandis que le noeud S est positionné à un niveau logique "0" par l'intermédiaire de la capacité $C_5$ connectée à la tension basse $V_{ss}$. De ce fait, la tension appliquée au circuit intégré présente la forme représentée par la courbe (d).

D'autre part comme représenté sur la figure 3, les diodes utilisées dans l'élévateur de tension 5 sont constituées par un transistor MOS T de type P dont les 3 électrodes sont connectées ensemble et forment la cathode IT et dont le caisson P forme l'anode A de la diode. Dans ce cas, on utilise la diode existant en direct entre le caison P et la diffusion nT. Ce mode de réalisation présente de nombreux avantages, notamment la tension de seuil des diodes est stable, elle est de 0,5 volt à 0,6 volt en fonction du process.

## Revendications

1. Circuit de remise à zéro à la mise sous tension, pour assurer le démarrage d'un circuit intégré en technologie MOS, caractérisé en ce qu'il comprend des premiers moyens (1) pour générer, à partir d'une tension d'alimentation ($V_{cc}$) du circuit, une tension ($V_{ccp}$) supérieure à ladite tension d'alimentation et un deuxième moyen (2) pour mesurer l'écart entre la tension d'alimentation et la tension générée et pour, générer un signal (S) de remise à zéro lorsque l'écart atteint un seuil donné après l'application de la tension d'alimentation.

2. Circuit selon la revendication 1, caractérisé en ce qu'il comporte de plus des moyens (3) pour arrêter le fonctionnement du circuit de remise à zéro une fois généré le signal de remise à zéro.

3. Circuit selon la revendication 1, caractérisé en ce que les premiers moyens sont constitués par un oscillateur (4) connecté à un élévateur de tension (5) délivrant en sortie une tension (Vccp) supérieure à la tension d'alimentation.

4. Circuit selon la revendication 3, caractérisé en ce que l'oscillateur est constitué par un nombre impair d'inverseurs (N1, I1, I2, I3, I4) montés en série, la sortie du dernier inverseur étant rebouclée sur l'entrée du premier inverseur.

5. Circuit selon l'une des revendications 3 ou 4, caractérisé en ce que l'élévateur de tension comprend une première diode (D1) montée en direct entre la borne d'alimentation (Vcc) et un premier nœud (C) de circuit, une première capacité (C1) montée entre le premier nœud (C) et la sortie d'un premier inverseur (I3), une deuxième diode (D2) montée en direct entre entre le premier nœud (C) et un deuxième nœud (D) de circuit et une deuxième capacité (C2) montée entre le deuxième nœud et la sortie d'un deuxième inverseur (I4) monté en série avec le premier inverseur. (I3), la sortie de l'élévateur étant prise sur le deuxième nœud.

6. Circuit selon la revendication 5, caractérisé en ce que l'élévateur de tension comporte de plus au moins un étage supplémentaire.

7. Circuit selon la revendication 6, caractérisé en ce que l'étage supplémentaire est constitué par une diode montée en direct entre un avant-dernier nœud de circuit et un dernier nœud formant la sortie de l'élévateur de tension et une capacité montée entre le dernier nœud et la sortie d'un inverseur supplémentaire monté en série avec les autres inverseurs.

8. Circuit selon la revendication 5, caractérisé en ce que l'élévateur de tension comporte de plus un étage de filtrage constitué par une diode (D3) montée en direct entre le dernier nœud (D) formant la sortie de l'élévateur de tension et un nouveau nœud (E) de sortie et une capacité (C3) montée entre ce nouveau nœud (E) et une tension basse ou masse (Vss).

9. Circuit selon l'une quelconque des revendications 5 ou 7, caractérisé en ce que, en technologie C-MOS, les diodes sont réalisées par un transistor MOS de type P dont les trois électrodes sont connectées ensemble et forment la cathode et dont le caisson N forme l'anode.

10. Circuit selon la revendication 1, caractérisé en ce que le deuxième moyen est constitué par un circuit de comparaison (T2, T1, T3) recevant respectivement sur chaque entrée la tension générée (Vccp) et la tension d'alimentation et délivrant en sortie un signal fonction de l'écart entre les deux tensions et par un circuit de détection et de mise en forme (N2) connecté en sortie du circuit de comparaison et générant le signal (S) de remise à zéro.

11. Circuit selon la revendication 10, caractérisé en ce que le circuit de comparaison est constitué par deux transistors MOS (T2, T1) de type n connectés en série entre un générateur de courant (13) et la tension basse ou masse (Vss).

12. Circuit selon la revendication 10, caractérisé en ce que ie circuit de détection et de mise en forme est constitué par une première porte inverseuse

(N2) à tension de seuil déterminé suivie d'un inverseur (N1).

13. Circuit selon l'une quelconque des revendications 2 à 12, caractérisé en ce que les moyens pour arrêter le fonctionnement du circuit une fois généré le signal remise à zéro sont constitués par des portes NON-OU (N1, N2) prévues respectivement dans la boucle de l'oscillateur et dans le circuit de détection et de mise en forme, ces portes NON-OU recevant sur une de leurs entrées le signal (S) de remise à zéro et par un moyen de blocage du générateur de courant (T3).

14. Circuit selon l'une quelconque des revendications 11 ou 13, caractérisé en ce que générateur de courant est constitué par un transistor MOS (T3) de type P dont une des électrodes est connectée à la tension d'alimentation (Vcc) et dont la grille est connectée au signal (S) de remise à zero.

## Patentansprüche

1. Schaltung zur Rücksetzung auf Null beim Anlegen von Spannung, zur Gewährleistung des Anlaufens einer integrierten Schaltung in MOS-Technologie, dadurch gekennzeichnet, daß sie erste Mittel (1) umfaßt, um aus einer Versorgungsspannung (Vcc) für die Schaltung eine Spannung (Vccp) zu erzeugen, die größer als die Versorgungsspannung ist, sowie zweite Mittel (2) zur Messung der Differenz zwischen der Versorgungsspannung und der erzeugten Spannung und zur Erzeugung eines Null-Rücksetzsignals (S), wenn die Differenz einen gegebenen Schwellwert nach dem Anlegen der Versorgungsspannung erreicht.

2. Schaltung nach Anspruch 1, dadurch gekennzeichnet, daß sie ferner Mittel (3) aufweist, um die Funktion der Null-Rücksetzschaltung zu beenden, sobald das Null-Rücksetzsignal erzeugt ist.

3. Schaltung nach Anspruch 1, dadurch gekennzeichnet, daß die ersten Mittel, die durch einen Oszillator (4) gebildet sind, welcher mit einem Spannungsübersetzer (5) verbunden ist, ausgangsseitig eine Spannung (Vccp) abgeben, die größer als die Versorgungsspannung ist.

4. Schaltung nach Anspruch 3, dadurch gekennzeichnet, daß der Oszillator durch eine ungerade Anzahl von in Reihe geschalteten Invertern (N1, I1, I2, I3, I4) gebildet ist, wobei der Ausgang des letzten Inverters auf den Eingang des ersten Inverters rückgeschleift ist.

5. Schaltung nach Anspruch 3 oder 4, dadurch gekennzeichnet, daß der Spannungsübersetzer eine erste Diode (D1) aufweist, die in Durchlaßrichtung zwischen dem Versorgungsanschluß (Vcc) und einem ersten Knotenpunkt (C) der Schaltung angeordnet ist, eine erste Kapazität (C1), die zwischen dem ersten Knotenpunkt (C) und dem Ausgang des ersten Inverters (I3) angeordnet ist, eine zweite Diode (D2), die in Durchlaßrichtung zwischen dem ersten Knotenpunkt (C) und einem zweiten Knotenpunkt (D) der Schaltung angeordnet ist, sowie eine zweite Kapazität (C2), die zwischen dem zweiten Knotenpunkt und dem Ausgang eines zweiten Inverters (I4) angeordnet ist, der mit dem ersten Inverter

(I3) in Reihe liegt, wobei der Ausgang des Spannungsübersetzers an dem zweiten Knotenpunkt abgenommen wird.

6. Schaltung nach Anspruch 5, dadurch gekennzeichnet, daß der Spannungsübersetzer ferner wenigstens eine weitere Stufe aufweist.

7. Schaltung nach Anspruch 6, dadurch gekennzeichnet, daß die weitere Stufe durch eine Diode gebildet ist, die in Durchlaßrichtung zwischen einem vorletzten Knotenpunkt der Schaltung und einem letzten Knotenpunkt angeordnet ist, welcher den Ausgang des Spannungsübersetzers bildet, sowie eine Kapazität, die zwischen dem letzten Knotenpunkt und dem Ausgang des weiteren Inverters angeordnet ist, der in Reihe mit den anderen Invertern liegt.

8. Schaltung nach Anspruch 5, dadurch gekennzeichnet, daß der Spannungsübersetzer ferner eine Filterstufe aufweist, die durch eine Diode (D3), welche in Durchlaßrichtung zwischen dem letzten Knotenpunkt (D), der den Ausgang des Spannungsübersetzers bildet, und einem neuen Ausgangs-Knotenpunkt (E) angeordnet ist, sowie eine Kapazität (C3) aufweist, die zwischen diesem neuen Knotenpunkt (E) und einer niedrigen Spannung oder Masse (Vss) angeordnet ist.

9. Schaltung nach Anspruch 5 oder 7, dadurch gekennzeichnet, daß bei Anwendung der C-MOS-Technologie die Dioden durch einen MOS-Transistor vom P-Typ gebildet sind, dessen drei Elektroden miteinander verbunden sind und die Kathode bilden und dessen Kasten N die Anode bildet.

10. Schaltung nach Anspruch 1, dadurch gekennzeichnet, daß das zweite Mittel durch eine Komparatorschaltung (T2, T1, T3) gebildet ist, die an jedem Eingang die erzeugte Spannung (Vccp) bzw. die Versorgungsspannung empfängt und am Ausgang ein Signal ausgibt, welches von der Differenz zwischen den zwei Spannungen abhängt, sowie durch eine Schaltung (N2) zur Detektion und Formgebung, welche am Ausgang der Komparatorschaltung angeordnet ist und das Null-Rücksetzsignal (S) erzeugt.

11. Schaltung nach Anspruch 10, dadurch gekennzeichnet, daß die Komparatorschaltung durch zwei MOS-Transistoren (T2, T1) vom n-Typ gebildet ist, die in Reihe zwischen einem Stromgenerator (13) und der niedrigen Spannung bzw. Masse (Vss) angeordnet sind.

12. Schaltung nach Anspruch 10, dadurch gekennzeichnet, daß die Schaltung zur Detektion und Formgebung durch eine erste invertierende Torschaltung (N2) mit gegebener Schwellspannung gebildet ist, gefolgt von einem Inverter (N1).

13. Schaltung nach einem der Ansprüche 2 bis 12, dadurch gekennzeichnet, daß die Mittel zum Beenden der Funktion der Schaltung, sobald das Null-Rücksetzsignal erzeugt ist, durch NOR-Torschaltungen (N1, N2) gebildet sind, die in der Oszillatorschleife bzw. in der Schaltung zur Detektion und Formgebung vorgesehen sind, wobei diese NOR-Torschaltungen an einem ihrer Eingänge das Null-Rücksetzsignal (S) empfangen, sowie durch eine Einrichtung zum Sperren des Stromgenerators (T3).

14. Schaltung nach Anspruch 11 oder 13, dadurch gekennzeichnet, daß der Stromgenerator durch einen MOS-Transistor (T3) vom P-Typ gebildet ist, dessen Elektroden mit der Versorgungsspannung (Vcc) verbunden sind und dessen Gate mit dem Null-Rücksetzsignal (S) verbunden ist.

**Claims**

1. A zeroizing circuit to operate on power-up, for starting operation of an MOS integrated circuit, characterized in that it comprises first means (1) in order to generate, from a supply voltage (Vcc) of the circuit, a voltage (Vccp) greater than the said supply voltage and a second means (2) in order to measure the difference between the supply voltage and the generated voltage and to generate a signal (S) for zeroizing when the difference reaches a given threshold after the application of the supply voltage.

2. The circuit as claimed in claim 1, characterized in that it furthermore comprises means (3) in order to hit operation of the zeroizing circuit once the zeroizing signal has been produced.

3. The circuit as claimed in claim 1, characterized in that the first means are in the form of an oscillator (4) connected with a voltage raising means (5) supplying at its output a voltage (Vccp) greater than the supply voltage.

4. The circuit as claimed in claim 3, characterized in that the oscillator is in the form of an odd number of inverters (N1, I1, I2, I3, and I4) placed in series, the output of the last inverter being connected back to the input of the first inverter.

5. The circuit as claimed in either of the preceding claims 3 and 4, characterized in that the voltage raising device comprises a first diode (D1) connected directly between the supply terminal (Vcc) and a first circuit junction (C), a first capacitor (C1) connected between the first junction (C) and the output of a first inverter (I3), a second diode (D2) connected directly between the first junction (C) and a second circuit junction (D) and a second capacitor (C2) placed between the second junction and the output of a second inverter (I4) connected in series with the first inverter (I3), the output of the voltage raising device being at the second junction.

6. The circuit as claimed in claim 5, characterized in that the voltage rising device further comprises at least one supplementary stage.

7. The circuit as claimed in claim 6, characterized in that the supplementary stage is constituted by a diode connected directly between a penultimate junction of the circuit and a last junction of the circuit forming the output of the voltage raising device and a capacitor connected between the last junction and the output of a supplementary inverter connected in series with the other inverters.

8. The circuit as claimed in claim 5, characterized in that the voltage rising device furthermore comprises a filtering stage in the form of a diode (D3) connected directly between the last junction (D) forming the output of the voltage raising device and a further output junction (E) and a capacitor (C3)

connected between this further junction (E) and a low voltage or ground ($V_{ss}$).

9. The circuit as claimed in either of the preceding claims 5 and 7, characterized in that the diodes, being C-MOS technology diodes, are in the form of an MOS transistor of the P type whose three electrodes are connected together and form the cathode and whose block N forms the anode.

10. The circuit as claimed in claim 1, characterized in that the second means is constituted by a comparison circuit ($T_2$, $T_1$, and $T_3$) receiving at each input, respectively, the generated voltage ($V_{ccp}$) and the supply voltage and supplying at an output a signal which is a function of the difference between the two voltages, and by a detection and reforming circuit ($N_2$) connected at the output with the comparison circuit and generating the signal (S) for zeroizing.

11. The circuit as claimed in claim 10, characterized in that the comparison circuit is constituted by two MOS transistors ($T_2$ and $T_1$) of the n type connected in series between a current generator (I3) and the low or ground voltage ($V_{ss}$).

12. The circuit as claimed in claim 10, characterized in that the detection and reforming circuit is constituted by a first inverting gate ($N_2$) with a given threshold voltage followed by an inverter ($N_1$).

13. The circuit as claimed in any, one of the preceding claims 2 through 12, characterized in that the means for halting the operation of the circuit once the zeroizing signal has been produced are constituted by NOT-OR gates ($N_1$ and $N_2$) provided respectively in the loop of the oscillator and in the detection and reforming circuit, said NOT-OR gates receiving at one of their inputs the signal (S) for zeroizing and by a means to disenable the current generator ($T_3$).

14. The circuit as claimed in either of the claims 11 and 13, characterized in that the current generator is constituted by an MOS transistor ($T_3$) of the P type whose one electrode is connected with the supply voltage ($V_{cc}$) and whose grid is connected with the zeroizing signal (S).

EP 0 296 930 B1

# FIG.1

ELEVATEUR DE TENSION — 5

OSCILLATEUR — 4

Vcc

Vccp

1

2

3

S

K — T — A

# FIG.3

FIG.2

FIG.4

EP 0 296 930 B1